# EUROPEAN PATENT SPECIFICATION

(11) **EP 1 221 686 B1**
(45) Date of publication and mention of the grant of the patent: **14.03.2007**
(21) Application number: 02000314.1
(22) Date of filing: 03.01.2002
(51) Int. Cl.: G09G 3/32

(54) **Driving circuit of an active matrix display with compensation of threshold voltage deviation**
Treiberschaltung für eine Anzeigevorrichtung mit aktiver Matrix mit Kompensation der Abweichung der Schwellspannung
Circuit d'attaque d'un affichage à matrice active avec compensation de deviation de la tension de seuil

(30) Priority: 05.01.2001 KR 2001000625
(43) Date of publication of application: 10.07.2002
(73) Proprietor: LG ELECTRONICS INC., Seoul (KR)
(72) Inventor: Pae, Han Su, Taegu-shi (KR); Na, Young Sun, Seoul (KR); Kwon, Oh Kyong, Seoul (KR); Kim, Hak Su, Suwon-shi, Kyonggi-do (KR)
(74) Representative: Heinze, Ekkehard

(56) References cited:
- EP-A- 0 905 673
- EP-A- 1 003 150
- WO-A-99/65012
- DAWSON R M A ET AL: "The impact of the transient response of organic light emitting diodes on the design of active matrix OLED displays" ELECTRON DEVICES MEETING, 1998. IEDM '98 TECHNICAL DIGEST., INTERNATIONAL SAN FRANCISCO, CA, USA 6-9 DEC. 1998, PISCATAWAY, NJ, USA,IEEE, US, 6 December 1998 (1998-12-06), pages 875-878, XP010321598 ISBN: 0-7803-4774-9

## Description

This application claims the benefit of the Korean Application No. P2001-00625 filed on January 5, 2001.

### Field of the Invention

The present invention relates to a driving circuit of an active matrix method in a display device.

### Discussion of the Related Art

Recently, various display devices such as an LCD device, a PDP device, an FED device and an EL device have been studied with development of flat display devices. These at display devices are classified into two according to a driving method, a passive matrix method and an active matrix method. At this time, it is required to use a higher level of current in the passive matrix method than the active matrix method.

Accordingly, in current driving methods of the LCD device and the PDP device, since greater current level is required with increasing the number of pixel, the passive matrix method is more efficient.

Meanwhile, in current driving methods of the FED and EL devices, it is regarded that the active matrix method is more efficient than the passive matrix method since it is required to use the higher level of current in the passive matrix method than the active matrix method even though a line time is equal.

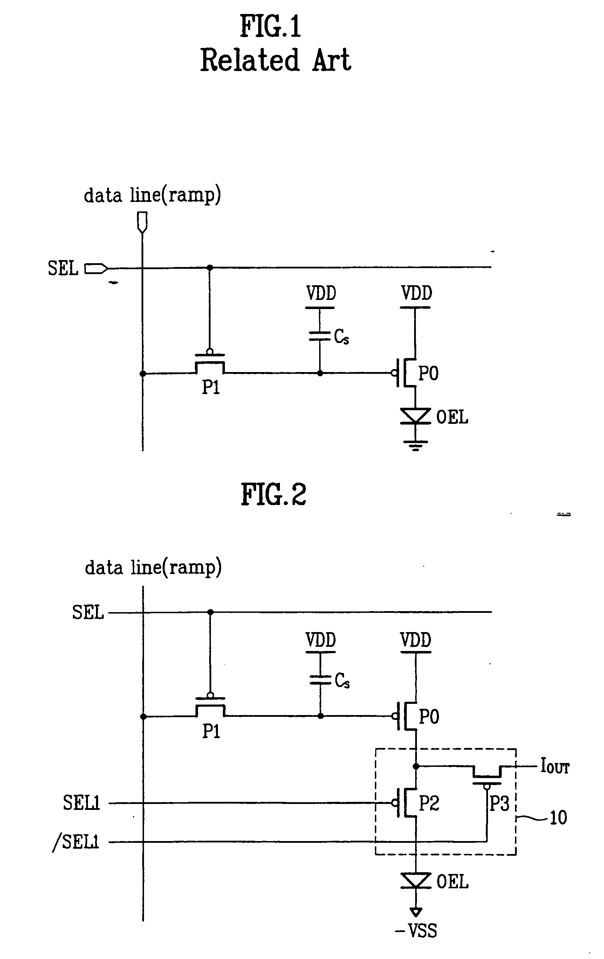

FIG. 1 is a circuit diagram of a driving circuit according to a related art active matrix method.

As shown in FIG. 1, the driving circuit includes a scan line SEL, a data line, a switch P1, a capacitor Cs, a driving transistor PO, an OEL and a positive power supply VDD.

At this time, the scan line SEL selects a pixel for driving, and the data line applies a voltage to the pixel. The switch P1 is served as an active device to control data input according to a signal of the scan line, and the capacitor Cs stores electric charges selected according to the voltage applied to the data line. Next, a voltage is input to the driving transistor PO by the electric charges stored in the capacitor Cs, and then the driving transistor PO applies a current to the OEL. The OEL emits light by the current applied from the driving transistor PO, and the positive power supply VDD supplies a power to the capacitor Cs and the driving transistor PO.

An operation of an active matrix method in a related art display device will be described in detail.

First, the pixel driven by the scan line SEL is selected, and then the pixel for driving is turned on by the switch P1. Then, a control voltage, in which a gray is controlled, is applied to the pixel for driving through the data line.

At this time, the control voltage is stored in the capacitor Cs, simultaneously, drives the driving transistor PO to make the OEL emit lights.

After the scan line is disabled, the driving transistor PO is driven by the voltage stored in the capacitor Cs to maintain one frame until the next select time.

However, since threshold voltages of the driving transistors used in the display device are different, the driving current for driving the OEL selected is not constant even though an equal driving voltage is applied to each driving transistor.

That is, each OEL emits different luminance according to deviation of the threshold voltages of the driving transistors.

To decrease the luminance deviation of the OEL according to the deviation of the threshold voltages of the driving transistors, it is required to constantly apply the driving current for driving the OEL without regard to the deviation of the threshold voltages of each driving transistor.

The deviation of the threshold voltages of the driving transistors is necessary consequence in fabricating process steps of the display device. Therefore, the luminance deviation of the pixels has to be compensated by detecting luminance of each pixel, however, it is hard to effectively compensate the luminance deviation.

Also, in the related art driving circuit, if a margin of the control voltage according to level of the driving current is small, it is hard to obtain desired luminance.

EP-A 1 003 150 relates to transistor circuits including driving transistors for controlling a driving current. The variance of voltage/current characteristics and thresholds in driving transistors, leading to variance of driving current to data signals and reducing the precision of the driving current, is discussed. It is proposed to introduce a compensating transistor into the circuit with its gate connected to either its source or drain, and which is connected to the gate of the driving transistor in an orientation so as to supply the input signals to that gate through source and drain of the compensating transistor and to allow the gate of the driving transistor to move electric charge into a direction to lower the conductance. Thus, the compensating transistor has diode characteristics.

WO 99 65012 A discloses an active matrix electroluminescent display with an array of current-driven electroluminescent display elements comprising organic electroluminescent material, whose operations are each controlled by an associated switching means to which a drive signal for determining a desired light output is supplied in a respective address period and which is arranged to drive the display element according to the drive signal following the address period. Each switching means comprises a current mirror circuit which samples and stores the drive signal and comprises a first transistor whose current-carrying electrodes are connected between a supply line and an electrode of the display element, a second transistor to whose gate electrode and first current-carrying electrode the drive signal is applied and whose second current-carrying electrode is connected to the supply line. The gate of the first transistor is connected to the supply line via a storage capacitor and to the gate of the second transistor via a switch device which is operable to connect the gates of the first and second transistors during the address period.

EP-A 0 905 673 discloses an active matrix display system with a LED or an OLED pixel structure with five transistors. This structure determines an offset voltage parameter using an autozeroing method which comprises a precharge phase, a auto-zero phase and a data writing phase. The auto-zero phase is essentially a current-drive mode of operation, where the drive current is very small. In the writing phase, the voltage on the LED is incremented above turn-on using the applied data voltage.

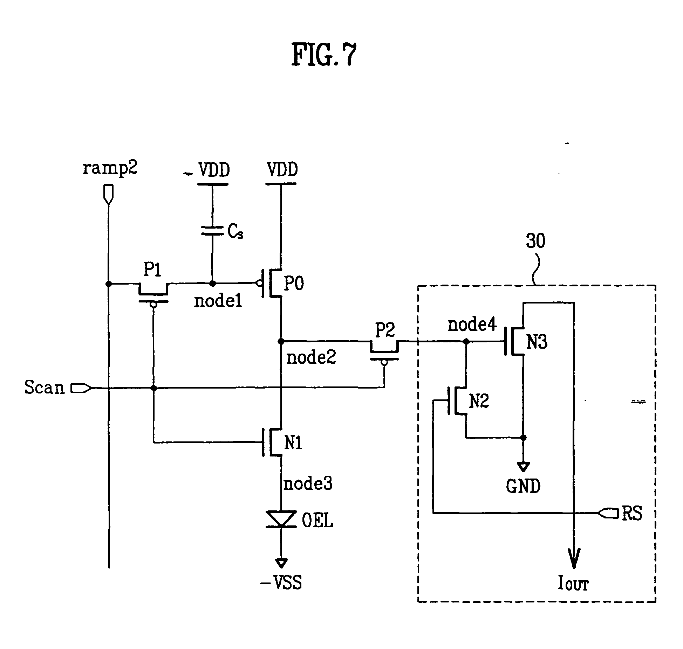

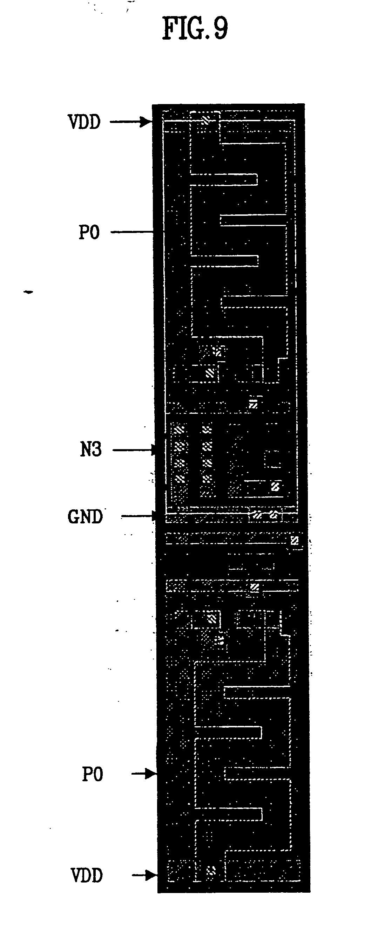

Dawson R.M.A. et al., 'The Impact of Transient Response of Organic Light Emitting Diodes on the Design of Active Matrix OLED Displays', Electron Devices Meeting, 1998; IEDM'98 Technical Digest., International San Francisco, CA, USA 6-9 Dec. 1998, Piscataway, NJ, USA, IEEE, US, 6. Dec. 1998, pages 875 - 878, ISBN 0-7803-4774-9, discusses the design of active matrix displays with OLEDs. Circuitries for current and voltage programmed OLED pixels are disclosed. Circuitries (Figs. 7, 9) comprise a first switch or transistor (MN1) connectable to a data line and to a scan line, which is adapted to switch an externally applied control voltage; further a driving unit (C1, MN2), its input being connected to the output of the first switch and adapted to store the control voltage applied by switching of the first switch; and an emitting pixel (OLED), which is connected to the driving unit such that a current is applied to the emitting pixel in dependence of the control voltage being stored in the driving unit.

It is further disclosed a second switch (MN3), which is adapted for switching a current applied to the emitting pixel by the control voltage applied from the driving unit directly back to the driving unit, without any further compensating circuitry.

### SUMMARY OF THE INVENTION

Accordingly, the present invention is directed to a driving circuit of an active matrix method in a display device that substantially obviates one or more problems due to limitations and disadvantages of the related art.

An object of the present invention is to provide a driving circuit of an active matrix method in a display device that can constantly improve luminance between pixels.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, a driving circuit of an active matrix display in a display device according to the present invention comprises a first switch connectable to a data line and to a scan line, adapted to switch an externally applied control voltage; a driving unit, its input being connected to the output of the first switch and adapted to store the control voltage applied by switching of the first switch; an emitting pixel, which is connected to the driving unit such that a current is applied to the emitting pixel in dependence of the control voltage being stored in the driving unit; and further a second switch, adapted for switching a current applied to the emitting pixel by the control voltage applied from the driving unit to a deviation compensator; and the deviation compensator, adapted for detecting the current applied to the emitting pixel and for controlling the control voltage, thereby compensating luminance deviation of the display device according to deviation of the threshold voltages of the driving unit.

According to an embodiment of the invention, the deviation compensator comprises a converter, adapted for converting the current switched from the second switch to a voltage, a comparator, adapted for comparing the voltage value converted by the converter with a reference voltage value, and a S & H circuit, adapted for receiving an external ramp voltage, and for outputting a certain ramp voltage to the data line according to result of the comparator.

According to a further embodiment of the invention, the S & H circuit is adapted to output the ramp voltage value constantly maintained to the data line when the converted voltage value is same as or lower than the reference voltage value, and the S & H circuit is adapted to bypass and output the external input ramp voltage value to the data line when the converted voltage value is higher than the reference voltage value.

According to further alternative embodiments of the invention, the first switch, the first and second transistors are PMOS transistors, and are respectively driven by different control signals, or the first switch and the second transistor are PMOS transistors and the first transistor is an NMOS transistor, the first switch, the first and second transistors being driven by an equal control signal.

According to a further embodiment, an amplifier formed between the second transistor and the deviation compensator is adapted to amplify the applied current by switching of the second transistor, and to input the amplified current to the deviation comparator.

According to a further embodiment, the amplifier comprises a third transistor having a gate connected to an output terminal of the second transistor, and is adapted for outputting the current amplified by a voltage difference between gate and source to the deviation compensator, and comprises a fourth transistor connected to gate and ground of the third transistor, and is adapted for controlling the voltage difference by an externally applied control signal.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

FIG. 1 is a circuit diagram of a driving circuit according to a related art active matrix method;

FIG. 2 is a circuit diagram of a driving circuit in an active matrix method according to the first embodiment of the present invention.

FIG. 3 is a block diagram illustrating a deviation compensator of a driving circuit according to the present invention;

FIG. 4 is a timing view illustrating each signal waveform according to the first embodiment of the present invention;

FIG. 5 is a circuit diagram of a driving circuit in an active matrix method according to the second embodiment of the present invention;

FIG. 6 is a timing view illustrating each signal waveform according to the second embodiment of the present invention;

FIG. 7 is a circuit diagram of a driving circuit in an active matrix method according to the third embodiment of the present invention;

FIG. 8 is a timing view illustrating each signal waveform according to the third embodiment of the present invention; and

FIG. 9 is a layout illustrating the third embodiment of the present invention.

### DETAILED DESCRIPTION OF THE INVENTION

Reference will now be made in detail to the preferred embodiments of the present invention, examples of which are illustrated in the accompanying drawings. Wherever possible, the same reference numbers will be used throughout the drawings to refer to the same or like parts.

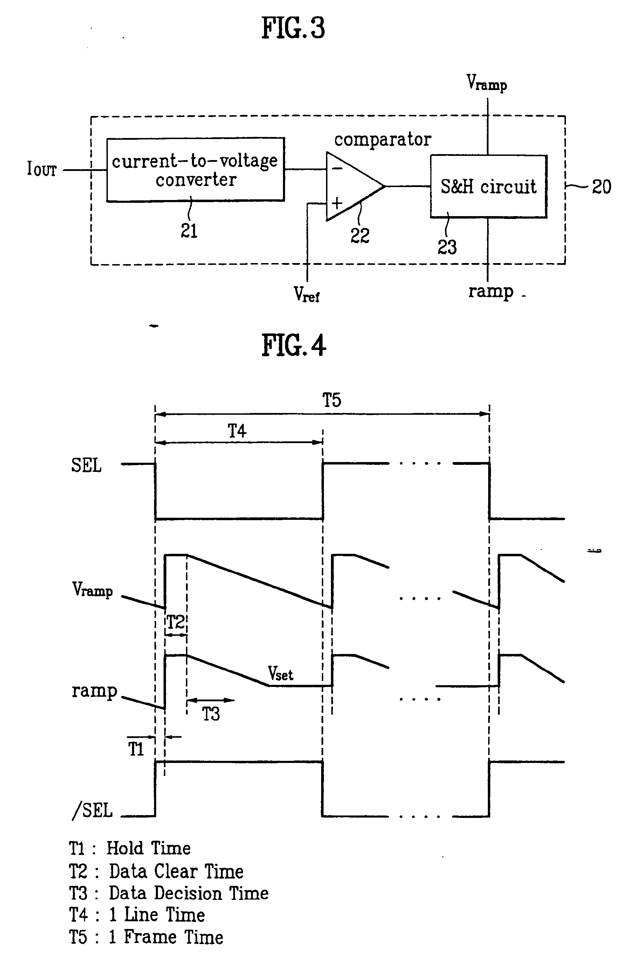

FIG. 2 is a circuit diagram of a driving circuit in an active matrix method according to the first embodiment of the present invention, and FIG. 3 is a block diagram illustrating a deviation compensator of the driving circuit according to the present invention.

As shown in FIG. 2 and FIG. 3, the driving circuit includes a transistor P1, a capacitor Cs, a driving transistor PO and a positive power supply VDD.

At this time, the transistor P1 connected data and scan lines switches an externally applied control voltage, and the capacitor Cs stores the control voltage by switching of the transistor P1. Next, the driving transistor PO makes an emitting pixel OEL emit lights by the control voltage applied from the capacitor Cs, and the positive power supply VDD supplies a power to the capacitor Cs and the driving transistor PO.

Also, the driving circuit further includes a switching unit 10 and a deviation compensator 20. The switching unit 10 connected between the driving transistor PO and the emitting pixel OEL switches a current applied to the emitting pixel OEL according to a voltage applied from the driving transistor PO. Also, the deviation compensator 20 detects the current applied to the emitting pixel OEL by switching of the switching unit 10, and controls the control voltage, so that luminance deviation of the emitting pixel OEL generated from threshold voltage deviation of the driving transistor PO is compensated.

At this time, the switching unit 10 includes a transistor P2 switching the current applied to the emitting pixel OEL by a control signal SEL1, and a transistor P3 switching the current applied to the deviation compensator 20 by a control signal /SEL1.

The transistors P1, P2 and P3 are PMOS transistors, and are driven by different control signals.

That is, the transistor P1 is driven by the control signal SEL, the transistor P2 is driven by the control signal SEL1, and the transistor P3 is driven by the control signal /SEL1.

As described above, in the present invention, the driving transistor PO is connected to the emitting pixel OEL by the transistor P2 unlike the related art in which the driving transistor PO is directly connected to the emitting pixel OEL.

As shown in FIG. 3, the deviation compensator 20 for compensating the luminance deviation of the emitting pixel OEL includes a current-to-voltage converter (I-to-V converter) 21, a comparator 22, and a sample & hold circuit (S & H circuit) 23. The current-to-voltage converter detects a driving current Iₒᵤₜ from the transistor P3 and converts the detected driving current to a voltage. The comparator 22 compares the voltage converted by the I-to-V converter 21 with a reference voltage Vref that is set to make the emitting pixel OEL emit lights at a predetermined luminance. To the sample & hold circuit 23, an external ramp voltage is applied. The sample & hold circuit 23 outputs a certain ramp voltage value to the data line according to result of the comparator 22.

At this time, the sample & hold circuit 23 constantly maintains the ramp voltage Vramp externally input at a point that the converted voltage value is same as the reference voltage value, and outputs the ramp voltage value constantly maintained to the data line.

Meanwhile, when the converted voltage value is higher than the reference voltage value, the externally input ramp voltage value Vramp is bypassed and is output to the data line.

FIG. 4 is a timing view illustrating each signal waveform according to the first embodiment of the present invention.

As shown in FIG. 4, if the emitting pixel OEL is selected by the control signal SEL, the transistors P1 and P2 are turned off, simultaneously, the transistor P3 is turned on by the control signal /SEL1.

At this time, the ramp voltage input through the data line drives the driving transistor PO by the transistor P1, and the deviation compensator 20 detects the driving current of the emitting pixel OEL by the transistor P3.

Referring to FIG. 3, the detected driving current is converted to the voltage by the current-to-voltage converter 21, and then the converted voltage is compared with the reference voltage by the comparator 22.

According to result of the comparator 22, the sample & hold circuit 23 bypasses and continuously outputs the externally input ramp voltage Vramp to the data line until the converted voltage value is same as the reference voltage value.

If the converted voltage value is same as or lower than the reference voltage value, the sample & hold circuit 23 constantly maintains the ramp voltage Vramp externally input at a point that the converted voltage value becomes same as the reference voltage value, and outputs the ramp voltage value constantly maintained to the data line.

At this time, the ramp voltage value constantly maintained is continuously output to the data line from a point that the converted voltage value becomes same as the reference voltage value to a point that the converted voltage value is higher than the reference voltage value.

The ramp voltage value Vramp constantly maintained is higher than the threshold voltage value of the driving transistor that drives the emitting pixel OEL, so that it is possible to solve a problem of the luminance deviation of the emitting pixel OEL according to the threshold voltage deviation of the driving transistor.

Subsequently, the ramp voltage value Vramp constantly maintained is stored in the capacitor Cs for storing electric charges by the data line.

Next, if corresponding emitting pixel OEL is selected by the control signal SEL, the transistors P1 and P2 are turned on, simultaneously, the transistor P3 is turned off by the control signal /SEL1.

Accordingly, the driving transistor PO of the corresponding emitting pixel OEL is driven by the capacitor Cs for storing the electric charges, and then the emitting pixels OEL emit lights by the driving current applied by the transistor P2 at a constant luminance.

As described above, the deviation compensator of the present invention outputs the ramp voltage value constantly maintained to the data line during a time period 'T1' (hold time), so that it is possible to solve a problem generated by luminance deviation of the emitting pixels OEL according to the threshold voltage deviation of the driving transistors.

Referring to FIG. 2, in the deviation compensator of the present invention, it may be used an amplifier having a high transimpedance value instead of the current-to-voltage converter 21.

In the related art driving circuit, if a margin of the control voltage according to a level of the driving current is small, it is hard to obtain desired luminance.

However, if the amplifier having the high transimpedance is used in the present invention, it is possible to obtain desired luminance since a margin of the control voltage according to a level of the driving current can be increased.

In another embodiment of the present invention, each switching device uses the scan line in common, thereby decreasing an area of the driving circuit, and increasing an emitting area.

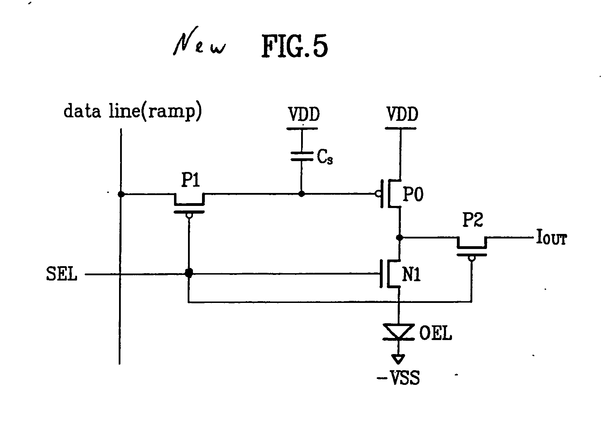

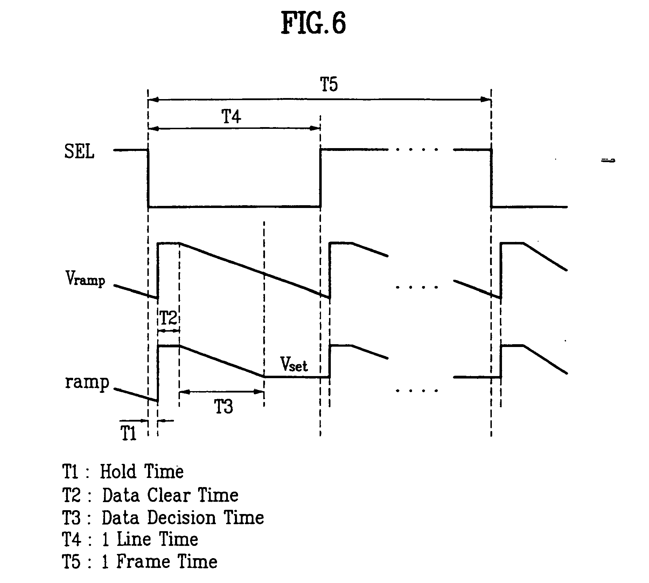

FIG. 5 is a circuit diagram of a driving circuit in an active matrix method according to the second embodiment of the present invention, and FIG. 6 is a timing view illustrating each signal waveform according to the second embodiment of the present invention.

As shown in FIG. 5, the second embodiment of the present invention is different to the first embodiment of the present invention in that a driving transistor PO is connected to a NMOS transistor N1, and NMOS transistor N1 and PMOS transistors P1 and P2 are controlled by an equal control signal SEL.

In the second embodiment of the present invention, the NMOS transistor N1 is used, so that it is not required to additionally apply a control signal applied to the transistor N1. That is, since the transistors P1 and P2 are conversely switched, the control signal SEL can control not only the PMOS transistors P1 and P2 but also the NMOS transistor N1.

Referring to FIG. 5 and FIG. 6, an operation of the driving circuit will be described in detail.

If corresponding emitting pixel OEL is selected by the control signal SEL, the transistors P1 and P2 are respectively turned on, simultaneously, the transistor N1 is turned off.

At this time, a ramp voltage input by a data line drives the driving transistor PO by the transistor P1, and a deviation compensator 20 detects a driving current of an emitting pixel OEL by the transistor P2.

Referring to FIG. 3 and FIG. 4, the deviation compensator 20 outputs the ramp voltage Vramp to the data line by the equal process, and the ramp voltage Vramp is stored in a capacitor Cs for storing electric charges by the data line.

Next, if the corresponding emitting pixel OEL is selected by the control signal SEL, the transistors P1 and P2 are respectively turned off , simultaneously, the transistor N1 is turned on.

Then, the driving transistor PO of the corresponding emitting pixel OEL is driven by the capacitor Cs for storing the electric charges, and the emitting pixels OEL emit lights at a constant luminance by the driving current applied by the transistor N1.

The other embodiment of the present invention will be described with reference to the accompanying drawings.

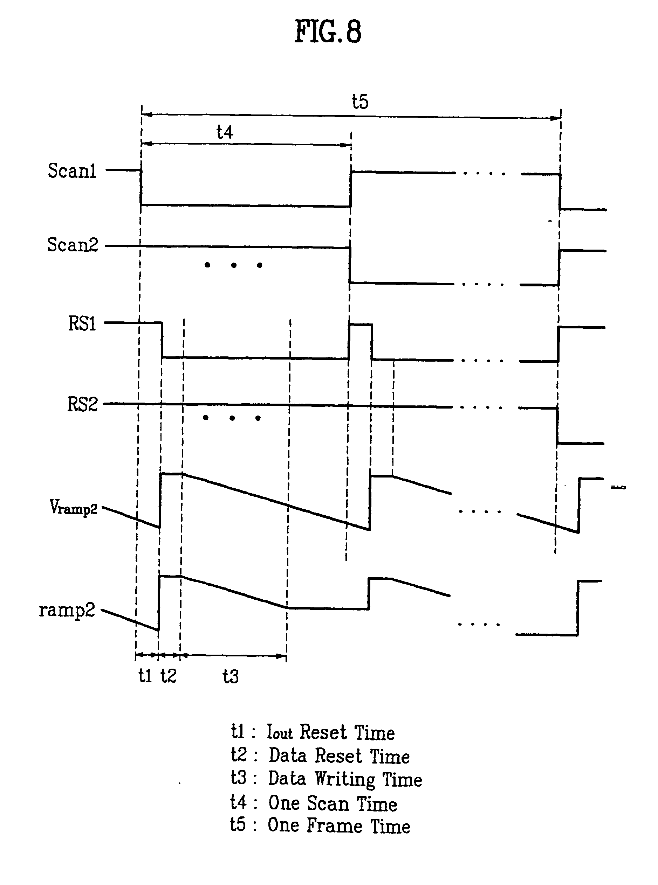

FIG. 7 is a circuit diagram of a driving circuit in an active matrix method according to the third embodiment of the present invention, and FIG. 8 is a timing view illustrating each signal waveform according to the third embodiment of the present invention.

Referring to FIG. 7, the third embodiment of the present invention is different to the first embodiment of the present invention in that a NMOS transistor N1 is formed between a node 2 and a node 3, and an amplifier 30 is formed between a transistor P2 and a deviation compensator 20.

At this time, the amplifier 30 amplifies a current applied by the transistor P2, and then input the current to the deviation compensator.

The amplifier 30 includes NMOS transistors N2 and N3.

A gate of the NMOS transistor N3 is connected to an output terminal of the transistor P2, and the NMOS transistor N3 outputs the amplified current to the deviation compensator by a voltage difference between gate and source.

The NMOS transistor N2 is respectively connected to gate and ground of the transistor N3, and controls the voltage difference between the gate and the source of the transistor N2 by an externally applied control signal.

The embodiment of the present invention includes the amplifier 30 since it is hard to detect a current level of Iₒᵤₜ in the deviation compensator if the current level of Iₒᵤₜ is low referring to FIG. 2 and FIG. 5.

Accordingly, in the third embodiment of the present invention, the transistors N2 and N3 are additionally formed to amplify the current level of Iₒᵤₜ.

As shown in FIG. 7, if the electric charges are stored in parasitic capacitance of a node 4, and Vgs (voltage between the gate and source) of the transistor N3 is increased, the amplified Iₒᵤₜ is output.

The driving circuit according to the third embodiment of the present invention has the following advantages.

First, the NMOS transistor N1 of FIG. 7 uses P-well of the transistors N2 and N3 in common with the transistors N2 and N3, thereby decreasing an area of layout.

Next, in case that a negative voltage is applied to the node 3, the NMOS transistor N1 of FIG. 7 maintains the node 3 at a voltage higher than -0.7V, thereby preventing the driving transistor PO from being over loaded.

Also, the driving current of the transistors N2 and N3 in the amplifier makes not only the emitting pixel OEL emit lights, but also an adjacent emitting pixel OEL (not shown) emit lights, thereby decreasing the area of layout referring to FIG. 9.

As shown in FIG. 7 and FIG. 8, an operation of the third embodiment of the present invention will be described as follows.

When the scan signal of FIG. 7 is applied during a time period 't4' of FIG. 8 that is called as one scan time, the transistors P1 and P2 respectively are turned on, and the transistor N1 is turned off.

During a time period 't1' of FIG. 8, a column line to which Iₒᵤₜ is output is cleared, and data in a node 1 is cleared by Vramp signal during a time period 't2'.

Also, a voltage applied to the node 1 during a time period 't3' is determined.

A process of time period 't4' is repeated as the number of total scan lines during a time period 't5' of FIG. 8.

FIG. 9 is a layout illustrating FIG. 7.

As shown in FIG. 9, the driving transistor PO of FIG. 7 is snake-shaped, so that it is useful to form a device having a long channel within a small pixel, and to enlarge the capacitor Cs of FIG. 7.

As described above, the driving circuit of the active matrix method in the display device according to the present invention has the following advantages.

First, it is possible to decrease the luminance deviation of the emitting pixels without regard to the deviation of the threshold voltages of the driving transistors, thereby improving uniformity of the luminance.

Furthermore, if the amplifier having the high transimpedance is used in the deviation compensator of the present invention, it is possible to obtain desired luminance since a margin of the control voltage according to the level of the driving current is large.

Finally, the transistor snake-shaped is used in the present invention, thereby decreasing the area of layout. Also, capacitance of the capacitor for storing electric charges can be improved.

It will be apparent to those skilled in the art than various modifications and variations can be made in the present invention. Thus, it is intended that the present invention covers the modifications and variations of this invention provided they come within the scope of the appended claims.

## Claims

1. A driving circuit of an active matrix display in a display device comprising:
a first switch (P1) connectable to a data line and to a scan line (SEL), adapted to switch an externally applied control voltage;
a driving unit (Cₛ, P0), its input being connected to the output of the first switch and adapted to store the control voltage applied by switching of the first switch (P1);
an emitting pixel (OEL), which is connected to the driving unit (Cₛ, PO) such that a current is applied to the emitting pixel (OEL) in dependence of the control voltage being stored in the driving unit (Cₛ, PO);
**characterized by**
a second switch (10), adapted for switching a current applied to the emitting pixel (OEL) by the control voltage applied from the driving unit to a deviation compensator (20); and
the deviation compensator (20), adapted for detecting the current applied to the emitting pixel (OEL) and for controlling the control voltage, thereby compensating luminance deviation of the display device according to deviation of the threshold voltages of the driving unit.

2. The driving circuit as claimed in claim 1,
**characterized in that**
the deviation compensator (20) comprises:
a converter (21), adapted for converting the current switched from the second switch (10) to a voltage,
a comparator (22), adapted for comparing the voltage value converted by the converter (21) with a reference voltage value (Vref), and
a S & H circuit (23), adapted for receiving an external ramp voltage (Vramp), and for outputting a certain ramp voltage (ramp) to the data line according to result of the comparator (22).

3. The driving circuit as claimed in claim 2,
**characterized in that**
the S & H circuit (23) is adapted to output the ramp voltage value (ramp) constantly maintained to the data line when the converted voltage value is same as or lower than the reference voltage value (Vref), and the S & H circuit (23) is adapted to bypass and output the external input ramp voltage value (Vramp) to the data line when the converted voltage value is higher than the reference voltage value (Vref).

4. The driving circuit as claimed in claim 1,
**characterized in that**
the deviation compensator (20) comprises:
a transimpedance amplifier (30), adapted for converting the current switched from the second switch to a voltage amplified,
a comparator (22), adapted for comparing the voltage converted by the transimpedance amplifier (30) with a reference voltage (Vref), and
a S & H circuit (23), adapted for receiving an external ramp voltage (Vramp) and for outputting a certain ramp voltage (ramp) to the data line according to result of the comparator (22).

5. The driving circuit as claimed in claim 4,
**characterized in that**
the S & H circuit (23) is adapted to output the ramp voltage value (ramp) constantly maintained to the data line when the converted voltage value is same as or lower than the reference voltage value (Vref), and the S & H circuit (23) is adapted to bypass and output the externally input ramp voltage value (Vramp) to the data line when the converted voltage value is higher than the reference voltage value (Vref).

6. The driving circuit as claimed in one of the preceding claims,
**characterized in that**
the second switch (10) comprises:
a first transistor (P2) formed between the driving unit (Cₛ, PO) and the emitting pixel (OEL), adapted to switch the current applied to the emitting pixel (OEL), and
a second transistor (P3) formed between the driving unit (Cₛ, PO) and the deviation compensator (20), adapted to switch the current applied to the deviation compensator (20).

7. The driving circuit as claimed in claim 6,
**characterized in that**
the first and second transistors (P2, P3) are PMOS transistors, and are driven by different control signals (SEL1, /SEL1).

8. The driving circuit as claimed in claim 6,
**characterized in that**
the first transistor is NMOS transistor (N1), and the second transistor is PMOS transistor (P2), the first and second transistors driven by an equal control signal (SEL).

9. The driving circuit as claimed in one of the preceding claims,
**characterized by**
an amplifier (30) formed between the second switch (10) and the deviation compensator (20), adapted to amplify the applied current by switching of the second switch (10), and to input the amplified current to the deviation compensator (20).

10. The driving circuit as claimed in claim 9,
**characterized in that**
the amplifier (30) comprises:
a third transistor (N3) having a gate connected to an output terminal of the second switch, and adapted for outputting the current amplified by a voltage difference between gate and source to the deviation compensator (20), and
a fourth transistor (N2) connected to gate and ground of the third transistor (N3), and adapted for controlling the voltage difference by an externally applied control signal (RS).

11. The driving circuit as claimed in claim 10,
**characterized in that**
the third and fourth transistors are NMOS transistors (N2, N3).

12. The driving circuit as claimed in claim 6,
**characterized in that**
the first switch, the first and second transistors are PMOS transistors, and are respectively driven by different control signals.

13. The driving circuit as claimed in claim 6,
**characterized in that**
the first switch and the second transistor are PMOS transistors and the first transistor is an NMOS transistor, the first switch, the first and second transistors being driven by an equal control signal.

14. The driving circuit as claimed in one of claims 6 to 13,
**characterized by**
an amplifier formed between the second transistor and the deviation compensator adapted to amplify the applied current by switching of the second transistor, and to input the amplified current to the deviation comparator.

15. The driving circuit as claimed in claim 14,
**characterized in that**
the amplifier comprises:
a third transistor having a gate connected to an output terminal of the second transistor, and adapted for outputting the current amplified by a voltage difference between gate and source to the deviation compensator, and
a fourth transistor connected to gate and ground of the third transistor, and adapted for controlling the voltage difference by an externally applied control signal.

16. The driving circuit as claimed in claim 15,
**characterized in that**
the third and fourth transistors are NMOS transistors.

## Patentansprüche

1. Ansteuerschaltung für eine Aktivmatrixanzeige in einer Anzeigeeinrichtung, die Folgendes aufweist:
einen ersten Schalter (P1), der an eine Datenleitung und an eine Abtastleitung (SEL) anschließbar ist und der für das Umschalten einer extern beaufschlagten Steuerspannung eingerichtet ist;
eine Ansteuereinheit (Cₛ, P0), deren Eingang mit dem Ausgang des ersten Schalters verbunden ist und die zur Speicherung der durch das Schalten des ersten Schalters (P1) beaufschlagten Steuerspannung eingerichtet ist;
ein Licht emittierendes Pixel (OEL), das mit der Ansteuereinheit (Cₛ, P0) verbunden ist, sodass das Licht emittierende (OEL) in Abhängigkeit von der in der Ansteuereinheit (Cₛ, P0) gespeicherten Steuerspannung mit einem Strom beaufschlagt wird;
**gekennzeichnet durch**
einen zweiten Schalter (10), der zum Umschalten eines Stroms, mit dem das Licht emittierende Pixel (OEL) **durch** die beaufschlagte Steuerspannung beaufschlagt wird, von der Ansteuereinheit zu einem Abweichungskompensator (20) eingerichtet ist; und
dem Abweichungskompensator (20), der für die Erkennung des Stroms, mit dem das Licht emittierende Pixel (OEL) beaufschlagt wird, und zur Steuerung der Steuerspannung eingerichtet ist, wodurch die Luminanzabweichung der Anzeigeeinrichtung entsprechend der Abweichung der Schwellenwertspannungen der Ansteuereinheit kompensiert wird.

2. Ansteuerschaltung nach Anspruch 1,
**dadurch gekennzeichnet,dass**
der Abweichungskompensator (20) Folgendes aufweist:
einen Konverter (21), der für die Umsetzung des vom zweiten Schalter (10) geschalteten Stroms in eine Spannung eingerichtet ist;
einen Komparator (22), der für den Vergleich des vom Konverter (21) umgesetzten Spannungswerts mit einem Referenzspannungswert (V_{ref}) eingerichtet ist, und
eine "Sample&Hold"-(S&H)-Schaltung (23), die für den Empfang einer externen Rampenspannung (Vᵣₐₘₚ) und für die Ausgabe einer bestimmten Rampenspannung (ramp) zur Datenleitung in Abhängigkeit vom Ergebnis des Komparators (22) eingerichtet ist.

3. Ansteuerschaltung nach Anspruch 2,
**dadurch gekennzeichnet, dass**
die S&H-Schaltung (23) zur Ausgabe des konstant aufrechterhaltenen Rampenspannungswerts (ramp) zur Datenleitung eingerichtet ist, wenn der umgesetzte Spannungswert gleich dem Referenzspannungswert (Vref) oder niedriger ist, und dass die S&H-Schaltung (23) zur Weiterleitung und Ausgabe des extern eingegebenen Rampenspannungswerts (Vramp) zur Datenleitung eingerichtet ist, wenn der umgesetzte Spannungswert höher als der Referenzspannungswert (Vref) ist.

4. Ansteuerschaltung nach Anspruch 1,
**dadurch gekennzeichnet , dass**
der Abweichungskompensator (20) Folgendes aufweist:
einen Transimpedanzverstärker (30), der für die Umsetzung des vom zweiten Schalter geschalteten Stroms in eine verstärkte Spannung eingerichtet ist;
einen Komparator (22), der für den Vergleich der vom Transimpedanzverstärker (30) umgesetzten Spannung mit einer Referenzspannung (Vref) eingerichtet ist; und
eine S&H-Schaltung (23), die für den Empfang einer externen Rampenspannung (Vramp) und für die Ausgabe einer bestimmten Rampenspannung (ramp) zur Datenleitung in Abhängigkeit vom Ergebnis des Komparators (22) eingerichtet ist.

5. Ansteuerschaltung nach Anspruch 4,
**dadurch gekennzeichnet, dass**
die S&H-Schaltung (23) zur Ausgabe des konstant aufrechterhaltenen Rampenspannungswerts (ramp) zur Datenleitung eingerichtet ist, wenn der umgesetzte Spannungswert gleich dem Referenzspannungswert (Vref) oder niedriger ist, und dass die S&H-Schaltung (23) zur Weiterleitung und Ausgabe des extern eingegebenen Rampenspannungswerts (Vramp) zur Datenleitung eingerichtet ist, wenn der umgesetzte Spannungswert höher als der Referenzspannungswert (Vref) ist.

6. Ansteuerschaltung nach einem der vorstehenden Ansprüche,
**dadurch gekennzeichnet, dass**
der zweite Schalter (10) Folgendes aufweist:
einen ersten Transistor (P2), der zwischen der Ansteuereinheit (Cₛ, P0) und dem Licht emittierenden Pixel (OEL) ausgebildet und für das Schalten des Stroms eingerichtet ist, mit dem das Licht emittierende Pixel (OEL) beaufschlagt wird, und einen zweiten Transistor (P3), der zwischen der Ansteuereinheit (Cₛ, P0) und dem Abweichungskompensator (20) ausgebildet und für das Schalten des Stroms eingerichtet ist, mit dem der Abweichungskompensator (20) beaufschlagt wird.

7. Ansteuerschaltung nach Anspruch 6,
**dadurch gekennzeichnet, dass**
der erste und der zweite Transistor (P2, P3) PMOS-Transistoren sind und dass sie von unterschiedlichen Steuersignalen (SEL1, /SEL1) gesteuert werden.

8. Ansteuerschaltung nach Anspruch 6,
**dadurch gekennzeichnet, dass**
der erste Transistor ein NMOS-Transistor (N1) und der zweite Transistor (P3) ein PMOS-Transistor ist, wobei der erste und der zweite Transistor von einem gleichen Steuersignal (SEL) gesteuert werden.

9. Ansteuerschaltung nach einem der vorstehenden Ansprüche,
**gekennzeichnet durch**
einen Verstärker (30), der zwischen dem zweiten Schalter (10) und dem Abweichungskompensator (20) ausgebildet ist und der zur Verstärkung des Stroms eingerichtet ist, der **durch** das Schalten des zweiten Schalters (10) beaufschlagt wird, sowie zur Eingabe des verstärkten Stroms in den Abweichungskompensator (20).

10. Ansteuerschaltung nach Anspruch 9,
**dadurch gekennzeichnet , dass**
der Verstärker (30) Folgendes aufweist:
einen dritten Transistor (N3) mit einem Gate, das mit einem Ausgangsanschluss des zweiten Schalters verbunden ist, und der für die Ausgabe des Stroms an den Abweichungskompensator (20) eingerichtet ist, der durch eine Spannungsdifferenz zwischen Gate und Source verstärkt wird; und einen vierten Transistor (N2), der mit dem Gate und Masse des dritten Transistors (N3) verbunden ist und der zur Steuerung der Spannungsdifferenz durch ein extern beaufschlagtes Steuersignal (RS) eingerichtet ist.

11. Ansteuerschaltung nach Anspruch 10,
**dadurch gekennzeichnet , dass**
der dritte und der vierte Transistor NMOS-Transistoren (N2, N3) sind.

12. Ansteuerschaltung nach Anspruch 6,
**dadurch gekennzeichnet, dass**
der erste Schalter, der erste und der zweite Transistor PMOS-Transistoren sind und dass sie jeweils von unterschiedlichen Steuersignalen angesteuert werden.

13. Ansteuerschaltung nach Anspruch 6,
**dadurch gekennzeichnet, dass**
der erste Schalter und der zweite Transistor PMOS-Transistoren sind und dass der erste Transistor ein NMOS-Transistor ist, wobei der erste Schalter und der erste und der zweite Transistor durch ein gleiches Steuersignal gesteuert werden.

14. Ansteuerschaltung nach einem der Ansprüche 6-13,
**gekennzeichnet durch**
einen Verstärker, der zwischen dem zweiten Transistor und dem Abweichungskompensator ausgebildet ist und der zur Verstärkung des Stroms eingerichtet ist, der **durch** das Schalten des zweiten Schalters beaufschlagt wird, sowie zur Eingabe des verstärkten Stroms in den Abweichungskompensator.

15. Ansteuerschaltung nach Anspruch 14,
**dadurch gekennzeichnet, dass**
der Verstärker Folgendes aufweist:
einen dritten Transistor mit einem Gate, das mit einem Ausgangsanschluss des zweiten Transistors verbunden ist, und der für die Ausgabe des Stroms an den Abweichungskompensator eingerichtet ist, der durch eine Spannungsdifferenz zwischen Gate und Source verstärkt wird; und einen vierten Transistor, der mit Gate und Masse des dritten Transistors verbunden ist und der zur Steuerung der Spannungsdifferenz durch ein extern beaufschlagtes Steuersignal eingerichtet ist.

16. Ansteuerschaltung nach Anspruch 15,
**dadurch gekennzeichnet, dass**
der dritte und der vierte Transistor NMOS-Transistoren sind.

## Revendications

1. Circuit d'attaque d'un affichage à matrice active dans un dispositif d'affichage comprenant :
un premier commutateur (P1) pouvant être relié à une ligne de données et à une ligne de balayage (SEL), apte à commuter une tension de commande appliquée extérieurement ;
une unité d'entraînement (Cₛ, P0), son entrée étant reliée à la sortie du premier commutateur et étant apte à stocker la tension de commande appliquée par la commutation du premier commutateur (P1);
un pixel émetteur (OEL) qui est relié à l'unité d'entraînement (Cₛ,PO) de telle sorte qu'un courant est appliqué au pixel émetteur (OEL) en fonction de la tension de commande stockée dans l'unité d'entraînement (Cₛ, P0) ;
**caractérisé par** :
un deuxième commutateur (10) apte à commuter un courant appliqué au pixel émetteur (OEL) par la tension de commande appliquée par l'unité d'entraînement à un compensateur d'écart (20) ; et
un compensateur d'écart (20) apte à détecter le courant appliqué au pixel émetteur (OEL) et à régler la tension de commande, en compensant ainsi l'écart de luminance du dispositif d'affichage selon l'écart des tensions de seuil de l'unité d'entraînement.

2. Circuit d'entraînement selon la revendication 1, **caractérisé en ce que** le compensateur d'écart (20) comprend :
un convertisseur (21) apte à convertir le courant commuté par le deuxième commutateur (10) en une tension,
un comparateur (22) apte à comparer la valeur de tension convertie par le convertisseur (21) avec une valeur de tension de référence (Vref), et un circuit S & H (23) apte à recevoir une tension de rampe externe (Vramp) et à émettre une certaine tension de rampe (ramp) à la ligne de données en accord avec le résultat du comparateur (22).

3. Circuit d'attaque selon la revendication 2, **caractérisé en ce que** le circuit S & H (23) est apte à émettre une valeur de tension de rampe (ramp) maintenue constamment à la ligne de données lorsque la valeur de tension convertie est la même ou inférieure à la valeur de tension de référence (Vref), et le circuit S & H (23) est apte à contourner et à émettre la valeur de tension de rampe externe entrée (Vramp) dans la ligne de données lorsque la valeur de tension convertie est plus élevée que la valeur de tension de référence (Vref).

4. Circuit d'attaque selon la revendication 1, **caractérisé en ce que** le compensateur d'écart (20) comprend :
un amplificateur d'adaptation d'impédance (30) apte à convertir le courant commuté du second commutateur à une tension amplifiée,
un comparateur (22) apte à comparer la tension convertie par l'amplificateur d'adaptation d'impédance (30) avec une tension de référence (Vref), et un circuit S & H (23) apte à recevoir une tension de rampe externe (Vramp) et à émettre une certaine tension de rampe (ramp) à la ligne de données en accord avec le résultat du comparateur (22).

5. Circuit d'attaque selon la revendication 4, **caractérisé en ce que** le circuit S & H (23) est apte à émettre la valeur de tension de rampe (ramp) maintenue constamment à la ligne de données lorsque la valeur de tension convertie est la même ou inférieure à la valeur de tension de référence (Vref), et le circuit S & H (23) est apte à contourner et à émettre la valeur de tension de rampe extérieurement entrée (Vramp) à la ligne de données lorsque la valeur de tension convertie est plus élevée que la valeur de tension de référence (Vref).

6. Circuit d'attaque selon l'une des revendications précédentes, **caractérisé en ce que** le second commutateur (10) comprend :
un premier transistor (P2) formé entre l'unité d'attaque (Cₛ,PO) et le pixel émetteur (OEL), apte à commuter le courant appliqué au pixel émetteur (OEL), et un second transistor (P3) formé entre l'unité d'attaque (Cₛ,PO) et le compensateur d'écart (20), apte à commuter le courant appliqué au compensateur d'écart (20).

7. Circuit d'attaque selon la revendication 6, **caractérisé en ce que** les premier et second transistors (P2, P3) sont des transistors PMOS et sont entraînés par des signaux de commande différents (SEL1/ SEL1).

8. Circuit d'attaque selon la revendication 6, **caractérisé en ce que** le premier transistor est un transistor NMOS (N1), et le deuxième transistor est un transistor PMOS (P2), les premier et second transistors étant entraînés par un signal de commande égal (SEL).

9. Circuit d'attaque selon l'une des revendications précédentes, **caractérisé par** un amplificateur (30) formé entre le second commutateur (10) et le compensateur d'écart (20) apte à amplifier le courant appliqué par la commutation du second commutateur (10) et à entrer le courant amplifié dans le compensateur d'écart (20).

10. Circuit d'attaque selon la revendication 9, **caractérisé en ce que** l'amplificateur (30) comprend :
un troisième transistor (N3) ayant une grille reliée à une borne de sortie du deuxième commutateur et apte à émettre le courant amplifié par une différence de tension entre la grille et la source au compensateur d'écart (20), et un quatrième transistor (N2) relié à la grille et à la masse du troisième transistor (N3), et apte à régler la différence de tension par un signal de commande (RS) appliqué extérieurement.

11. Circuit d'attaque selon la revendication 10, **caractérisé en ce que** les troisième et quatrième transistors sont des transistors NMOS (N2, N3).

12. Circuit d'attaque selon la revendication 6, **caractérisé en ce que** le premier commutateur, les premier et second transistors sont des transistors PMOS et sont respectivement entraînés par des signaux de commande différents.

13. Circuit d'attaque selon la revendication 6, **caractérisé en ce que** le premier commutateur et le deuxième transistor sont des transistors PMOS et que le premier transistor est un transistor NMOS, le premier commutateur, les premier et second transistors étant entraînés par un signal de commande égal.

14. Circuit d'attaque selon l'une des revendications 6 à 13, **caractérisé par** un amplificateur formé entre le deuxième transistor et le compensateur d'écart apte à amplifier le courant appliqué par une commutation du deuxième transistor et à entrer le courant amplifié dans le comparateur d'écart.

15. Circuit d'attaque selon la revendication 14, **caractérisé en ce que** l'amplificateur comprend :
un troisième transistor ayant une grille reliée à une borne de sortie du deuxième transistor et apte à émettre le courant amplifié par une différence de tension entre la grille et la source au compensateur d'écart, et un quatrième transistor relié à la grille et à la masse du troisième transistor et apte à commander la différence de tension par un signal de commande appliqué extérieurement.

16. Circuit d'attaque selon la revendication 15, **caractérisé en ce que** les troisième et quatrième transistors sont des transistors NMOS.
